# EUROPEAN PATENT APPLICATION

(11) **EP 4 826 397 A1**
(43) Date of publication of application: **21.10.2026**
(21) Application number: 25170292.4
(22) Date of filing: 14.04.2025
(51) Int. Cl.: G01R 31/12

(54) **DETECTING PARTIAL DISCHARGES IN MEDIUM AND HIGH VOLTAGE EQUIPMENT**

(71) Applicant: ABB SCHWEIZ AG, 5400 Baden (CH)
(72) Inventor: ACKERMANN, Patric, 64347 Griesheim (DE); KAUL, Holger, 68165 Mannheim (DE); GEBHARDT, Joerg, 55130 Mainz (DE); HENCKEN, Kai, 79539 Lörrach (DE)
(74) Representative: Maiwald GmbH

(57) **Abstract**

A method (100) for detecting partial discharges in medium or high voltage equipment (1) based on measurement data (3) recorded by at least one sensor (2), the method (100) comprising the steps of:
• determining (110) whether the measurement data (3) comprises at least one partial discharge contribution (4) that
∘ is plausible to have been produced by the occurrence of a partial discharge pulse somewhere in the equipment (1) and propagation of the resulting signal to the at least one sensor (2) and that
∘ reappears repeatedly in a statistical manner,
wherein the determining whether a contribution is plausible to be a partial discharge contribution (4) comprises: in response to determining (111) that a plurality of pulses have a consistent pulse form given by the propagation or transfer of the signal from their source to the at least one sensor (2), determining (112) that the pulses are partial discharge pulses coming from the same origin; and
• if at least one such partial discharge contribution (4) is present, determining (120) that partial discharges are occurring in the equipment (1).

## Description

### FIELD OF THE INVENTION

The invention relates to the monitoring of medium and high voltage equipment for partial discharges under voltage stress.

### BACKGROUND

When a dielectric material is put under voltage stress between two electrodes, it may exhibit localized dielectric breakdowns that bridge only part of the distance between the electrodes. These localized dielectric breakdowns are called partial discharges. Partial discharges frequently start at voids, inclusions or other imperfections in the dielectric material. Contamination of the dielectric material, such as the surface of an insulator, is another frequent cause of partial discharges. If partial discharges persist too long, the integrity of the dielectric material may erode over time, up to the point where the insulation fails completely and the circuit shorts out. There is therefore a desire to monitor medium and high voltage equipment for partial discharges.

For partial discharge detection in switchgear or other air or gas-insulated devices, different PD sensors or detection systems are employed: capacitive sensors, HF current sensors, radio-wave based UHF sensors, TEV (Transient earth voltage) sensors, or acoustic sensors. Capacitive and HF current sensors are often expensive to retrofit and potentially introduce a point of failure, e.g. due to loss of dielectric insulation. Similarly to TEV sensors, they can determine the partial discharge origin to be on a specific electrical connection or phase or within a certain compartment or range of compartments, but they cannot localize it in the spatial domain, that is pointing out their specific position. Both acoustic and UHF sensors are often used for this localization. In general, several sensors are installed, and a time-of-flight approach is used for this. With only a single sensor installed, there is no such possibility; in addition, such systems cannot cope with reflections or other distortions of the line-of-flight, as they are based on a direct time-of-flight approach. They can also not cope with the existence of more than one partial discharge source term, as they add the signal from both of them, which is a general problem of single-sensor partial discharge systems. This poses the risk, that an intensive but harmless partial discharge signal masks a more damaging, smaller one. For the effort that is proposed in order to overcome these problems using a number of sensors, see e.g. US 10,488,487 B2, where a dedicated calibration is procedure is proposed for the UHF case.

### OBJECTIVE OF THE INVENTION

It is therefore an objective of the present invention to allow for a more exact and reliable detection of partial discharge events in medium or high voltage equipment with a moderate effort in terms of sensor equipment.

This objective is achieved by the method according to the independent claim. Further advantageous embodiments are detailed in the dependent claims.

### DISCLOSURE OF THE INVENTION

The invention provides a method for detecting partial discharges in medium or high voltage equipment based on measurement data recorded by at least one sensor. The measurement data may, for example, comprise time series data of a measurement value recorded by the at least one sensor.

In the course of the method, the measurement data is analyzed for partial discharge contributions. That is, it is determined whether the measurement data comprises at least one partial discharge contribution. If at least one such partial discharge contribution is present, it is determined that partial discharges are occurring in the equipment.

Herein, a partial discharge contribution to the measurement data is any contribution that:
- is, according to any suitable criterion, plausible to have been produced by the occurrence of a partial discharge pulse somewhere in the equipment and propagation of the resulting signal to the at least one sensor and
- reappears repeatedly in a statistical manner.

In particular, the reappearing in a statistical manner is a characteristic property of partial discharge events. If the equipment is under AC voltage, the electric field strength rises and falls periodically. Every time the local electric field is above the field strength that causes the localized breakdown, a new partial discharge event will be triggered. Herein, there is a small variation in where exactly at the site of the fault the new partial discharge event will happen and how much voltage will be required to trigger it. One reason for this is that each partial discharge event will leave the material in a slightly different configuration regarding the spatial distribution of charges and electric field strength. Therefore, a partial discharge event that manifests itself in a contribution to the measurement data cannot be expected to repeat itself exactly. But it can be expected that every partial discharge event that occurs at one given site of a fault will produce a substantially similar signature in the measurement data. In particular, the repeated signals from one and the same site can be expected to have a substantially similar shape. In particular, this may mean that variations in time of the measurement data induced by repeated partial discharge events from one and the same site are significantly correlated to each other. For example, this may be quantified by a correlation coefficient between such variations in time pertaining to different events being above a given threshold.

The propagation from the site of the fault to the sensor, such as a microphone or an electromagnetic sensor, may be described by a complex (in terms of "complicated", but not necessarily "complex-valued") transfer function. For example, an acoustic signal may be reflected multiple times in an enclosure housing switchgear. But each and every time a signal propagates from a particular site of a fault to the sensor, it will be processed by the same transfer function because the geometry remains the same. Thus, to merely detect the presence of partial discharge contributions, it is not required to understand the complex transfer function in detail.

On top of this, it is important that a partial discharge contribution is plausible to have been produced by a partial discharge pulse in the first place. Not every signal contribution that reappears periodically under AC voltage has been produced by partial discharges. For example, a transformer will emit an audible hum due to electromagnetic forces even if no partial discharge events are occurring. But it is characteristic for localized dielectric failures that they produce short discharge pulses.

That is, once there is a breakdown, all locally available charges flow across this breakdown.

Therefore, in the course of the present method, the determining whether a contribution is plausible to be a partial discharge contribution comprises: in response to determining that a plurality of pulses have a consistent pulse form given by the propagation or transfer of the signal from their source to the at least one sensor, determining that the pulses are partial discharge pulses coming from the same origin.

That is, in the course of the method, for every partial discharge contribution from one and the same origin, a characteristic pulse form (or "impulse response") of each pulse arriving at the sensor that is determined by the fault itself and by the transfer function for propagation to the sensor may be learned.

The inventors have found that, in this manner, from the measurement data picked up by one single sensor, signals that indicate partial discharge events at multiple locations in the equipment may be extracted. This means that monitoring with one single sensor may be sufficient to monitor equipment for the occurrence of partial discharge events.

The mere presence of a partial discharge contribution can already be used as a trigger for maintenance work. In particular, the new appearing of a particular partial discharge contribution may be used as a sign that something has degraded in the equipment. For example, if the measurement data from the monitoring of a high voltage transmission line previously only comprised a partial discharge contribution produced by inevitable, harmless corona discharges, but now a strong new partial discharge contribution appears, this may indicate that a solid insulator is beginning to fail. Thus, in response to the appearing of a new partial discharge contribution, a maintenance action on the monitored equipment may be initiated.

In a practical example, measurement data may be collected at a sampling rate that is higher than 10*c/D, more preferably higher than 100*c/D and most preferably higher than 1000*c/D. Herein, c is the propagation speed of the measured signal/property (such as sound or electromagnetic waves), and D is the characteristic distance of the geometry that governs propagation from the site of the fault to the used sensor. For example, D may correspond to the size of an enclosure housing the equipment, or to the distance of the used sensor from the most distant part of the equipment that may exhibit partial discharge. The measurement data may be sampled at least during a time interval T=D/c, preferably T=10*D/c. In particular, the time interval T may be longer than 20 ms, and optimally longer than 100 ms.

The method may be used to determine the time and relative strength of partial discharge events with a very good time resolution on the order of 1-10 µs. This output may be generated per location of partial discharge events, so multiple combinations of times and strengths may be determined.

Optionally, the "fingerprint" of each partial discharge event, i.e. the impulse response per identified location of partial discharge events, may be determined. This may be stored in a library by some other method to determine if partial discharge events at a particular location are a) a new occurrence, b) an existing occurrence, or c) have been resolved by a service visit. For an existing occurrence (case b), a trend of the strength may be computed, so as to determine whether the equipment is in a steady state or whether it is deteriorating.

Partial discharge events may be resolved much better than conventional methods like peak detection algorithm. For example, it was demonstrated that events down to an apparent charge of less than 100 pC in typical medium voltage applications In high voltage applications even higher sensitivities are expected They may be resolved down to strengths as low as 20 % of the strongest partial discharge event in the area, often even down to strengths as low as 10 % of the strongest partial discharge event in the area.

In a particularly advantageous embodiment, in response to determining that an essentially common pulse form or a part thereof is distributed statistically at different instance in time within the measurement signal, it is determined that at least one partial discharge contribution is present. That is, the measurement data may be examined for the presence of repeatedly occurring pulses without having to know the concrete pulse form in advance. This is done with the help of a so-called "detector". Rather, as discussed before, once it has been determined that a certain pulse form occurs repeatedly (the indicator), this pulse form may be learned (as a transfer function). In one example, pulses may be determined to be of an essentially common pulse form in response to their respective signals in time being highly correlated among each other, and/or having a high pattern coincidence. But a repetitive pattern may just as well also be found by other means.

That is, in a further particularly advantageous embodiment, the presence of a consistent or essentially common pulse form is determined by computing at least one correlation between the measurement data or a part thereof within a certain time interval on the one hand, and a version of the measurement data or a part thereof shifted in time to another time interval on the other hand. Many combinations of time intervals and shifts may be tested .

In a further particularly advantageous embodiment, from at least one partial discharge contribution, the transfer function for propagation of the signal of a partial discharge pulse to the at least one sensor is determined. This aids the localization of the site of the fault in space, e.g., within a cabinet or other enclosure. That is, even if only one single sensor is present, some estimate of the site of the fault may be made. This saves time for tracking down the fault in detail.

In a further particularly advantageous embodiment, based at least in part on the transfer function, a pulse shape of at least one partial discharge pulse may be determined. The pulse shape gives hints as to the concrete physical nature of the failure, which may further aid the localization of the fault and the more precise identification of the problem, thereby speeding up the repair. Resolving the pulse shape is particularly advantageous if the pulse comprises electromagnetic waves, e.g., an ultra-high frequency, UHF, signal.

In a further particularly advantageous embodiment, the determining of the transfer function is performed based at least in part on a priori knowledge about the shape of the partial discharge pulse. That is, if there is such a priori knowledge, it is easier to disentangle the original pulse shape and the modification of this pulse shape by the transfer function. For example, the pulse may be assumed to be a delta function pulse. But as discussed before, the mere detection of partial discharge events is not dependent on any such a priori knowledge because pulse shapes may be self-learned.

In particular, starting points for lengths and/or scales of time intervals investigated, and/or choice of correlation times considered, may be determined based at least in part on the a priori knowledge. If it is known at least to some extent what is being looked for, the detection is made quicker and more precise. Some examples of time scales have been given above.

In a further particularly advantageous embodiment, the determining of the transfer function is based on a model of the propagation that comprises reflection of signals or waves (such as sound) on walls, and/or diffraction and/or deflection of signal on obstacles and/or attenuation of the signal by the media and/or the distance it travels through. That is, if the geometry of the equipment (such as an arrangements of busbars and insulators in an enclosure) is known, this may yield an at least approximate idea of the transfer function. The better the transfer function is known, the better the presence of PD may be determined and in addition the site of a fault may be localized.

In a further particularly advantageous embodiment, determining a source-specific signature in the measurement data of a partial discharge pulse from one source comprises coherent averaging of signatures in the measurement data of multiple partial discharge pulses from the same source. In this manner, statistical variations in the pulse are averaged out, and the signature better represents the true characteristics of the partial discharge transfer function. This improved signature can then be used as an estimation of the true transfer function

In a further particularly advantageous embodiment, the determining of at least one partial discharge contribution comprises:
- obtaining a signature that at least one partial discharge pulse is produced in the measurement data; and
- searching the measurement data for one or more instances of this signature.

Herein, the initially obtained signature may come from any suitable source. In particular, if a signature has been self-learned from the measurement data, further occurrences of this signature may be searched for in order to obtain the complete partial discharge contribution of one particular location to the measurement data. But the signature may also be determined from a priori knowledge. But it can also be determined with the help of a method that operates as a "detector". One example is the "robust detector" that will be described later. By obtaining a signature once and then searching for more instances of it, much effort is saved because the obtaining of the signature may be expensive.

In particular, a time interval to be used to search for one or more instances of the signature may be determined based at least in part on the signature and/or the position of this signature in the measurement data as indicated by a "detector", e.g., a "robust detector" that will be described later.. In this manner, the self-learned knowledge (and/or a priori knowledge) is immediately put to use when searching for further instances of the signature, thereby expanding one signature to a complete partial discharge contribution of one location to the measurement data.

In a further particularly advantageous embodiment, alternatively or in combination to the measurement data and/or the signature, a frequency representation and/or time-frequency representation of the measurement data is investigated for the presence of at least one partial discharge contribution. That is, the measurement data is examined in the frequency domain. For example, the representation may be obtained using Fourier transform, short time Fourier transform, wavelet transform, a similar functional analytical or integral transform, and/or a spectrogram. Investigating the representation means to search for partial discharge contributions in the manner described above. Some signatures of partial discharge events may be more evident in the frequency domain than they are in the time domain.

In a further particularly advantageous embodiment, the determining whether the measurement data comprises at least one partial discharge contribution comprises detection of a signal energy and/or power introduced into the air or space by a partial discharge event and arriving at the detection unit. Calculating in terms of signal energy and/or power facilitates calculating gains and losses in dB. Moreover, a partial discharge event may be correlated to a positive introduction of energy and/or power.

In particular, the detection of energy or power may comprise evaluating a power spectral density of the measurement data in a predetermined or automatically adjusted frequency range. This facilitates the detection of a positive introduction of power.

That is, in a further particularly advantageous embodiment, the detection of energy or power may comprise:
- calculating, from the measurement data, a root mean square of the introduced power, and/or of an energy average;
- calculating the expected signal decay due to reflections at walls, the inverse distance law, or the attenuation by the medium;
- removing or correcting the effects of this decay from the root mean square, thereby obtaining a corrected power; and
- in response to determining that the corrected power contains at least one positive change as a function of the time, determining that this positive change corresponds to at least one partial discharge pulse.

This means, inter alia, that a mere reflection of the signal at a wall will not be mistaken for a partial discharge event at a particular location.

Determining and evaluating frequency representations, as well as detecting signal energy and/or power, may be performed using analog electronics, such as bandpass filters. The advantage of this is that computation time is saved.

In a further particularly advantageous embodiment, from the measurement data and the transfer function that is known by whatever means (e.g., known a priori, or determined in the course of the present method), a precise moment in time, or a precise phase angle with respect to an AC voltage, at which a partial discharge event occurs is determined. This allows to determine the moment in time with an accuracy better than 1 ms, preferably better than 1 µs. This can be preferably or advantageously used to provide Phase Resolved Partial Discharge (PRPD) patterns, which are key to analyzing the type and therefore severity of the partial discharge.

In a further particularly advantageous embodiment, from the at least one partial discharge contribution, a (relative) strength of the partial discharge is determined. This allows to assess the severity of the partial discharge. In particular, it can be determined whether partial discharge events at a particular location remain at the same strength, or whether they increase in strength because the fault that gives rise to them is worsening.

In a further particularly advantageous embodiment, the determining of the strength of the partial discharge comprises:
- obtaining, based on at least one signature of the partial discharge, calibration information; and
- computing the strength of the partial discharge based at least in part on a strength of the partial discharge contribution and the calibration information.

That is, the signature indicates how strong the partial discharge contribution to the measurement data will be given a certain strength of the partial discharge event in terms of transferred charge.

In a further particularly advantageous embodiment, multiple partial discharge contributions are determined from the measurement data. In this manner, partial discharge events occurring at different locations may be disentangled from one another. As discussed before, this helps to distinguish, e.g., between harmless corona discharges and discharges that indicate an imminent catastrophic insulation failure.

In a further particularly advantageous embodiment, in response to determining that the measurement data comprises at least one partial discharge contribution,
- this partial discharge contribution is removed from the measurement data, thereby producing remaining to-be-analyzed measurement data; and
- it is determined whether this remaining to-be-analyzed measurement data comprises at least one further partial discharge contribution.

That is, the measurement data may be analyzed in an iterative manner. In particular, strong partial discharge contributions may be removed first from the measurement data, which may reveal weaker partial discharge contributions. It would be much more difficult to directly separate such very differently strong partial discharge contributions in one go.

In a further particularly advantageous embodiment, from the transfer function,
- a distance between the location of the partial discharge event and the at least one sensor, and/or
- a path between the location of the partial discharge event and the at least one sensor, and/or
- whether the partial discharge event occurs only in one location or in multiple locations
is evaluated. As discussed before, this information is helpful to localize the fault that gives rise to the partial discharge, as well as to assess the severity of this fault.

Thus, in a further particularly advantageous embodiment, the method further comprises: determining, based at least in part on the transfer function and/or the pulse shape and/or the temporal or phase distribution of partial discharge events from this location, a severity rating of the partial discharge pulse with regard to proper functioning of the equipment. In particular, this severity rating may be used to prioritize maintenance actions. For example, maintenance of a piece of equipment may be deemed to be the more urgent the closer this piece of equipment is to a catastrophic insulation failure.

In a further particularly advantageous embodiment, the severity rating is dependent at least on whether at least one partial discharge contribution has always been present during operation of the equipment or has set in at a later point in time during this operation. As discussed before, a partial discharge contribution that has set in at a later time is indicative of a deterioration of the state of health of the equipment.

In a further particularly advantageous embodiment, the measurement is based on an acoustic signal or measurement principle. A single acoustic sensor may be sufficient to monitor a whole switchgear cabinet, or even multiple cabinets.

Alternatively or in combination to this, the measurement may be based on an electromagnetic wave signal or measurement principle, such as UHF. The advantage of an electromagnetic wave signal is its capability to detect internal partial discharges as it does propagate through both solid and gaseous substances.

Because it may be fully or at least partially computer-implemented, the present method may be embodied in the form of a software. The invention therefore also relates to a computer program with machine-readable instructions that, when executed by one or more computers and/or compute instances, cause the one or more computers and/or compute instances to perform the method described above. Examples for compute instances include virtual machines, containers or serverless execution environments in a cloud. The invention also relates to a machine-readable data carrier and/or a download product with the computer program. A download product is a digital product with the computer program that may, e.g., be sold in an online shop for immediate fulfilment and download to one or more computers. The invention also relates to one or more compute instances with the computer program, and/or with the machine-readable data carrier and/or download product.

An exemplary implementation of the method works as follows:
In a first step, the input signal is bandpass filtered, and the time-resolved average acoustic power within this frequency band BP1 within a temporal window T1 is determined. Here one typically uses 100µs<T1<20ms. The bandpass is chosen with an ultrasonic frequency band from 10kHz to 400kHz. This is done to account for the short temporal structure of the acoustic signal generated and to reduce the sensitivity of the sensor for other acoustic events within the enclosure. The temporal derivative *D =* $\frac{d \left〈BP1\right〉}{dt}$ of the average acoustic power <BP1> is computed to be used by the detector.

Positive values of the derivative being above a threshold indicate that the acoustic signal of a partial discharge, PD, event may have arrived at the sensor. The averaging time for the average acoustic power <BP1> is chosen appropriately to include the full first reflections of the acoustic impulse received from the walls in order to have only one peak of the derivative D per PD event and at the same time to still distinguish consecutive PD events. This detector could already be used to report on PD activity within the enclosure, as the signal is roughly proportional to the strength of the PD discharge. However, the detection approach lacks good correlation between amplitude of the signal and the PD strength (e.g. the apparent charge). Even more problematic: The time resolution of the approach is limited by the temporal width of the averaging window, which itself is limited by the spacing of the first reflections and hence the enclosure dimensions. Therefore time-resolution better than 0.5ms is very unlikely to be achieved. Furthermore, small PD events are hard to detect, especially when following a stronger partial discharge.

In the second step, we use the fact, that the PD creates a repeatable acoustic impulse (i.e. temporal shape of the local sound pressure level) at the source. The acoustic signal shape at the receiver is then a convolution of the sensors' impulse response, the impulse response of the enclosure for the specific source position S and receiver position M and the impulse response of the source.

For a given PD source S, the algorithm identifies and isolates the corresponding impulse response or "signature" of each PD source without the need of an additional reference signal. For this identification, the algorithm first only searches for signatures at temporal positions, for which the robust detector of step 1 shows a positive signal, corresponding to strong signals, that correspond very likely to PD signals.

In contrast to prior art in which a detector is described that searches for a fixed pattern, our algorithm does not rely on fixed precomputed patterns, but identifies signatures, such as acoustic signatures, from the signal. Hence it is agnostic and adaptive to variations in physical position and dimensions of the enclosure, different microphone characteristics and placement.

This signature is then further postprocessed and especially normalized such that it can be searched for in the signal. The search is normally done by multiplying the expected signal shape with the signal aligned at different time delays and search for matches corresponding to a high value of the summed product.

The method of this search step is designed such, that it not only reports a relative time within the (acoustic) signal at which the PD happened, but also the relative magnitude of the PD.

The special feature of the algorithm is, that it is able to determine the relative times of each PD event down to well below 100µs accuracy. An absolute time of the event can then be determined, when the travel time of the sound between the source and the microphone is known by other means. But as the origin of the PD source is the same, in many cases the relative time is sufficient for each source. A precise time is important in order to be able to do phase-resolved analyses, even if an absolute phase cannot be determined.

Another special feature of the algorithm is that it can distinguish between PD generated at different positions S1, S2... inside the enclosure. This is because the pattern of reflected signals, such as acoustic waves, is a function of both, source and sensor position. The algorithm then needs to be extended to identify not only one, but several typical signal forms.

The sensitivity of the method can be enhanced by an appropriate placement of the sensor with respect to the possible sources of PD, and to make sure that every expected relevant PD position exhibits a unique (acoustic) signature and hence can be distinguished from one another.

In one possible embodiment of the invention, the algorithm would report either the complete signature or some kind of unique identifier of the PD source together with the times and strengths of the corresponding PD happening in locations S1, S2....

In a further special embodiment of the invention, the signatures for each source are multiplied with an appropriately computed relative amplitude, to completely remove the sound received from location S1 from the signal. In the remaining difference signal, sound recorded from a second PD position S2 could be identified, which otherwise would be covered by the large magnitude of the S1 acoustic signal.

Hence the knowledge of the acoustic impulse response (signature) for each PD source is crucial and beneficial for a PD detection system of high sensitivity.

In laboratory tests using only one microphone with real geometries including obstacles obscuring both the direct and the first reflections of the acoustic path between source and sensor three types of PD haven been already successfully detected by the algorithm down to >100pC of apparent PD strength: Corona PD, Surface PD and Floating PD.

In a further special embodiment of the invention, the signatures for each source and the corresponding amplitudes of occurrences are analyzed to compute a relative PD strength comparable to the "apparent charge" (IEC 60270). This analysis may include computing the peak amplitude, RMS amplitude, temporal peak spacings and envelope of the signature.

Whereas the main advantage of this methods has been the use of only a single sensor, it is also clear, that an extension to multiple sensors is straight-forward and might even increase the accuracy or sensitivity of it. In the case of more than one sensor the time delay from the source to the sensor will in general not be the same, therefore the algorithm to detect a potential partial discharge presence as well as determining the transfer function need to be extended, especially in terms of the time interval analyzed to cope with this.

### DESCRIPTION OF THE FIGURES

In the following, the invention is described using Figures without any intention to limit the scope of the invention. The Figures show:
Figure 1: Exemplary embodiment of the method 100 for detecting partial discharges;
Figure 2: Exemplary propagation of acoustic partial discharge pulses in an enclosure with and without obstacles;
Figure 3: Exemplary acoustic measurement data and partial discharge contributions 4 evaluated from it;
Figure 4: Exemplary signatures of partial discharge events from one particular location with and without obstacles in the acoustic propagation path.

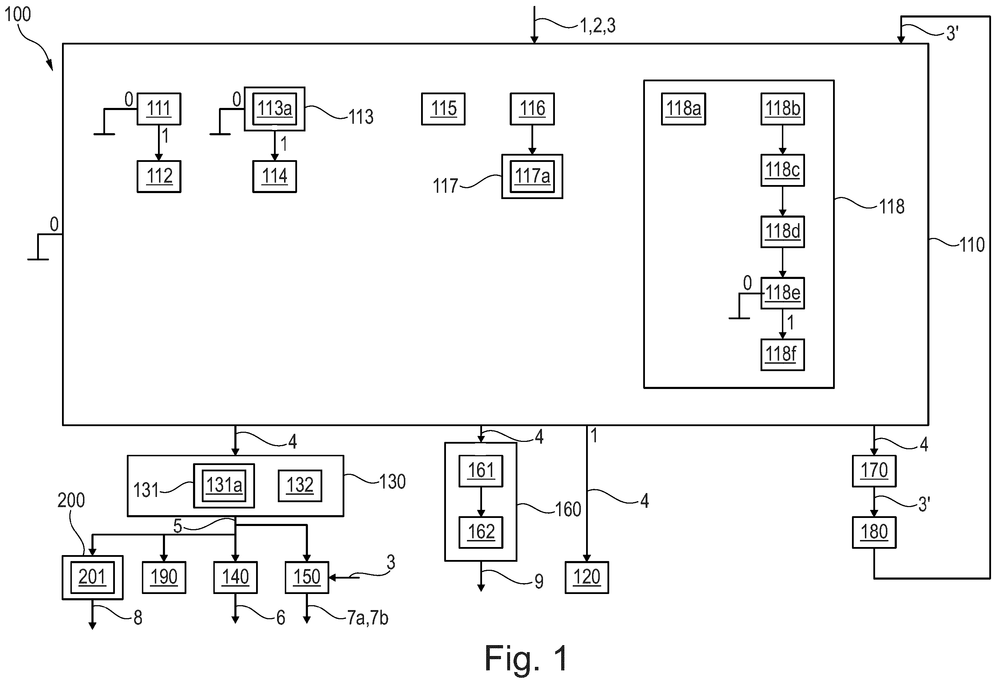

Figure 1 is a schematic flow chart of an embodiment of the method 100 for detecting partial discharges in medium or high voltage equipment 1. The method 100 starts from a situation where the equipment 1 is monitored by at least one sensor 2 that records measurement data 3.

In step 110, it is determined whether the measurement data 3 comprises at least one partial discharge contribution 4 that
- is plausible to have been produced by the occurrence of a partial discharge pulse somewhere in the equipment 1 and propagation of the resulting signal to the at least one sensor 2 and that
- reappears repeatedly in a statistical manner.

Herein, according to block 111, it is determined whether a plurality of pulses have a consistent pulse form given by the propagation or transfer of the signal from their source to the at least one sensor 2. If this is the case (truth value 1), according to block 112, it is determined that the pulses are partial discharge pulses coming from the same origin.

According to block 113, it may be determined whether an essentially common pulse form or a part thereof is distributed statistically at different instance in time within the measurement signal. If this is the case (truth value 1), according to block 114, it may be determined that at least one partial discharge contribution 4 is present.

According to block 115, determining a signature in the measurement data 3 of a partial discharge pulse from one source may comprise coherent averaging of signatures in the measurement data 3 of multiple partial discharge pulses from the same source.

According to block 116, a signature that at least one partial discharge pulse produced in the measurement data 3 may be obtained. According to block 117, the measurement data may then be searched for one or more instances of this signature.

According to block 118, the determining 110 whether the measurement data 3 comprises at least one partial discharge contribution 4 may comprise detection of a signal energy and/or power introduced into the air or space by a partial discharge event or absorbed by the detection unit.

In particular, according to block 118a, the detection of energy or power may comprise evaluating a power spectral density of the measurement data 3 in a predetermined or automatically adjusted frequency range.

According to block 118b, from the measurement data 3, a root mean square of the introduced power, and/or an energy average, may be calculated. According to block 118c, the expected signal decay due to reflections at walls may then be calculated. According to block 118d, the effects of this decay may be removed or corrected from the root mean square. This yields a corrected power. According to block 118e, it may then be determined whether the corrected power contains at least one positive change as a function of the time. If this is the case (truth value 1), according to block 118f, it may be determined that this positive change corresponds to at least one partial discharge pulse.

If it has been determined in step 110 that at least one partial discharge contribution 4 is present (truth value 1), in step 120, it is determined that partial discharges are occurring in the equipment 1.

In step 130, from at least one partial discharge contribution 4, the transfer function 5 for propagation of the signal of a partial discharge pulse to the at least one sensor 2 may be determined.

According to block 131, the determining of the transfer function 5 may be performed based at least in part on a priori knowledge about the shape of the partial discharge pulse. In particular, according to block 131a, starting points for lengths and/or scales of time intervals investigated, and/or choice of correlation times considered, may be determined based at least in part on the a priori knowledge.

According to block 132, the determining of the transfer function 5 may be based on a model of the propagation that comprises reflection of (sound) signals or waves on walls, and/or diffraction and/or deflection of signal on obstacles and/or attenuation of the signal by the media and/or the distance it travels through.

In step 140, based at least in part on the transfer function 5, a pulse shape 6 of at least one partial discharge pulse may be determined.

In step 150, from the measurement data 3 and the known transfer function 5, a precise moment in time 7a, or a precise phase angle 7b with respect to an AC voltage, at which a partial discharge event occurs may be determined.

In step 160, from the at least one partial discharge contribution 4, a (relative) strength 9 of the partial discharge may be determined.

According to block 161, based on at least one signature of the partial discharge, calibration information may be obtained. According to block 162, the strength 9 of the partial discharge may then be computed based at least in part on a strength of the partial discharge contribution and the calibration information.

In step 170, an identified partial discharge contribution 4 may be removed from the measurement data. This produces remaining to-be-analyzed measurement data 3'. In step 180, it may then be determined whether this remaining to-be-analyzed measurement data 3' comprises at least one further partial discharge contribution 4.

That is, the remaining to-be-analyzed measurement data 3' may be fed back into step 110 for determining more, potentially weaker partial discharge contributions 4.

In step 190, from the transfer function 5,
- a distance between the location of the partial discharge event and the at least one sensor 2, and/or
- a path between the location of the partial discharge event and the at least one sensor 2, and/or
- whether the partial discharge event occurs only in one location or in multiple locations
may be evaluated.

In step 200, based at least in part on the transfer function 5 and/or the pulse shape and/or the temporal or phase distribution of partial discharge events from this location, a severity rating 8 of the partial discharge pulse with regard to proper functioning of the equipment 1 may be determined.

In particular, according to block 201, the severity rating 8 may be dependent at least on whether at least one partial discharge contribution 4 has always been present during operation of the equipment 1 or has set in at a later point in time during this operation.

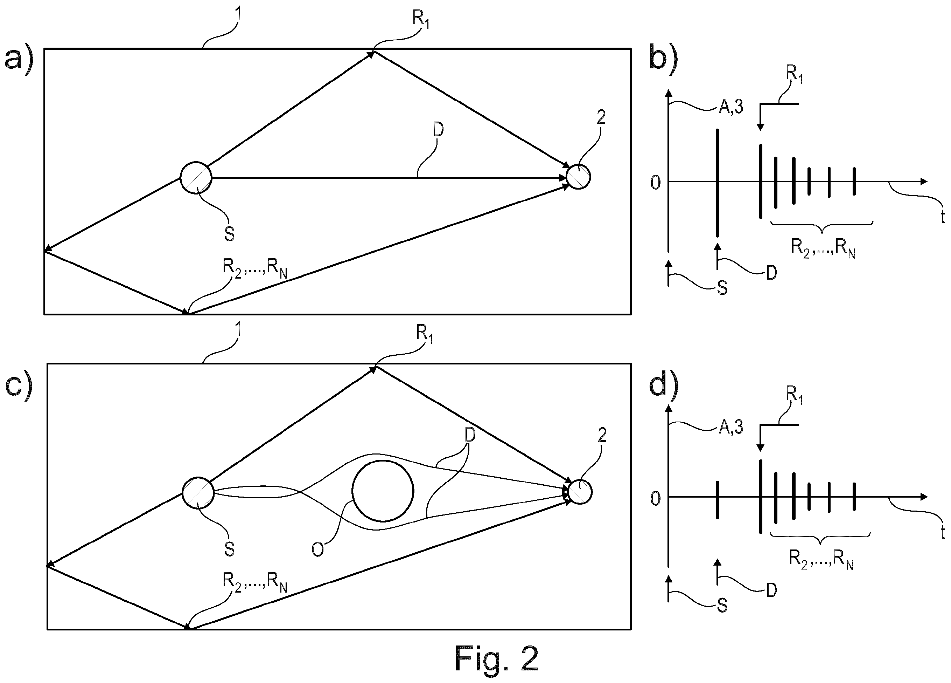

Figure 2 shows how delta function shaped pulses emanating from a source S inside equipment 1 are transformed into acoustic measurement data 3 depending on the geometry of the equipment 1.

Figure 2a illustrates a simple situation where the source S is in direct line-of-sight to at least one sensor 2. In this manner, a direct signal D is able to propagate in a straight line from the source S to the sensor 2. At the same time, the pulse will also propagate on indirect paths by means of reflections R₁, ..., R_{N}.

Figure 2b illustrates the resulting amplitude A of the measurement signal 3.Compared with the original pulse S, the direct signal D is attenuated somewhat. The reflections R₁, ..., R_{N} are attenuated even further and come at different times depending on the lengths of the respective propagation paths.

Figure 2c illustrates a little more complex situation where there is an additional obstacle O in the enclosure of the equipment 1. This means that the direct signal D is diffracted by the obstacle O.

Figure 2d illustrates the effect of this diffraction on the amplitude A of the measurement signal 3. Compared with Figure 2b, the direct signal D is attenuated and therefore weaker than the reflected signals.

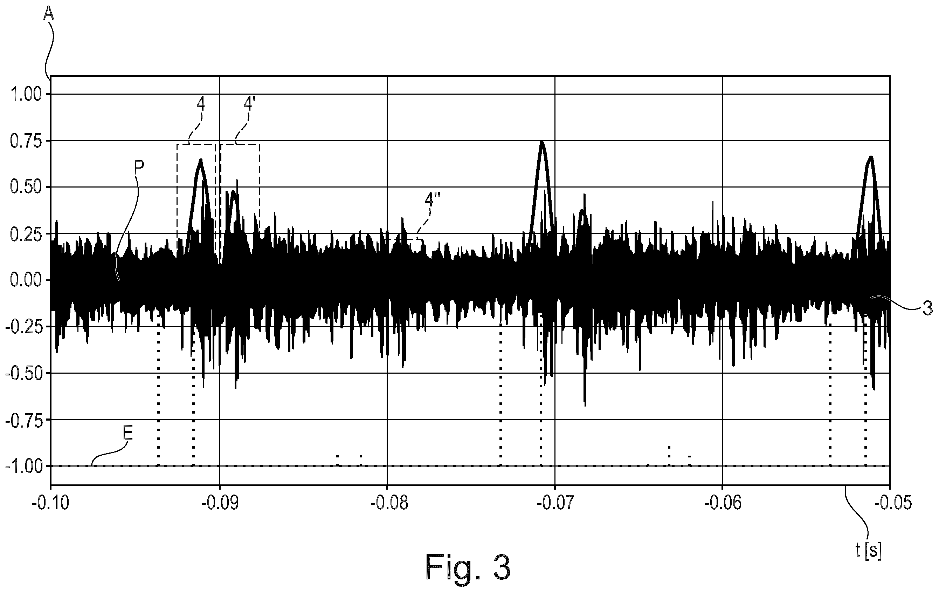

Figure 3 illustrates the determining of partial discharge contributions 4 and their signature from the acoustic power P derived from acoustic measurement data 3. This acoustic power P is the signal used for the "robust detector". As a ground truth reference, an electrical signal E whose pulses indicate partial discharge events is plotted in Figure 3 as well. A pulse in the electrical signal E produces a pulse in the acoustic power P that is delayed because the signal takes time to propagate from the site of the fault to the sensor 2.

In Figure 3, there are at least three partial discharge contributions 4,4' and 4" visible that can be said to repeat in a statistical manner. These partial discharge contributions 4,4' and 4" can be easily identified by the "robust detector" from the acoustic power P.

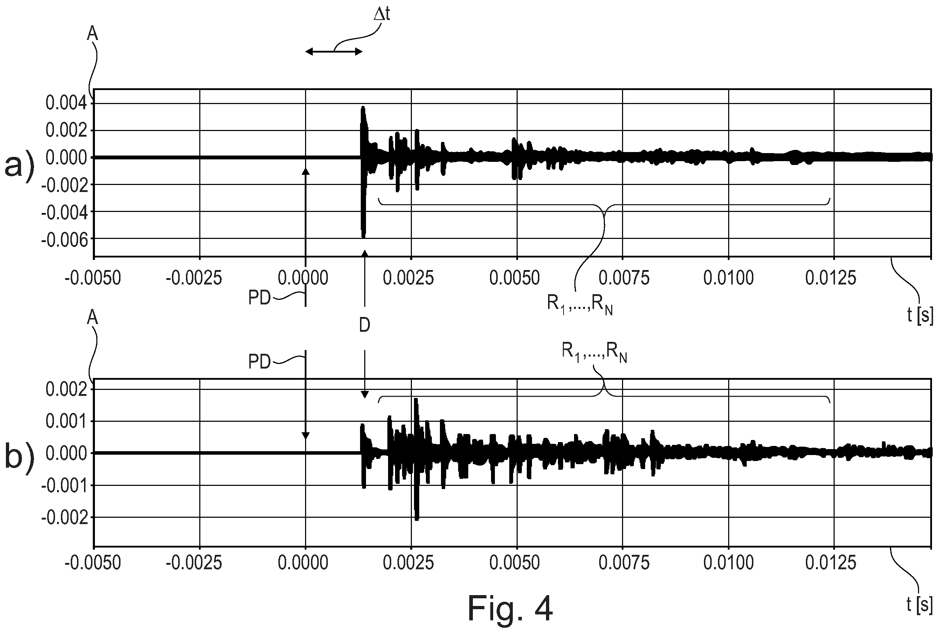

Figure 4 illustrates marks, in terms of signatures and/or the transfer function, that partial discharge events from a particular location leave in the measurement data 3. The amplitude A of the measurement signal 3 is plotted over the time, averaged over more than 20 partial discharge events. Figure 4a relates to the geometry of the equipment 1 shown in Figure 2a (without obstacle O between source S and sensor 2), whereas Figure 2b relates to the geometry of the equipment 1 shown in Figure 2c (with obstacle O between source S and sensor 2). For both geometries, a respective distinct signature emerges. The signature is delayed with respect to the partial discharge event by the sound travel time Δt.

### List of reference signs:

- 1: equipment
- 2: sensor
- 3: measurement data
- 3': remaining to-be-analyzed measurement data
- 4, 4', 4": partial discharge contributions
- 5: transfer function
- 6: pulse shape of partial discharge pulse
- 7a: moment in time of partial discharge pulse
- 7b: moment in AC phase of partial discharge pulse
- 8: severity rating of partial discharge event
- 9: strength of partial discharge event
- 100: method for detecting partial discharges
- 110: determining whether partial discharge contributions are present
- 111: determining whether pulses have consistent pulse form
- 112: determining that pulses are partial discharge pulses
- 113: determining that common pulse form is distributed statistically
- 113a: computing correlation
- 114: determining that partial discharge contribution is present
- 115: determining signature by coherent averaging
- 116: obtaining signature of partial discharge pulse
- 117: searching for signature in measurement data 3
- 117a: determining search parameters based on signature
- 118: detecting signal energy and/or power
- 118a: evaluating power spectral density
- 118b: calculating root mean square
- 118c: calculating expected decay
- 118d: removing or correcting decay effects
- 118e: determining whether positive change is present
- 118f: determining that positive change corresponds to partial discharge pulse
- 120: determining that partial discharges are occurring
- 130: determining transfer function 5
- 131: using a priori knowledge about pulse shape
- 131a: setting starting points of parameters based on a priori knowledge
- 132: using model of propagation/diffraction/deflection/attenuation
- 140: determining pulse shape 6 based on transfer function 5
- 160: determining relative strength 9 of partial discharge event
- 161: determining calibration information
- 162: determining strength 9 using calibration information
- 170: removing partial discharge contribution 4 from measurement data 3
- 180: analyzing remaining measurement data 3 'for PD contributions 4
- 190: further evaluating transfer function 5
- 200: determining severity rating 8 of partial discharge event
- 201: using later onset of events in severity rating 8
- A: amplitude of signal
- D: direct signal
- O: obstacle
- R₁-R_{N}: reflected signals
- S: source of partial discharge events
- t: time
- Δt: sound travel time

## Claims

1. A method (100) for detecting partial discharges in medium or high voltage equipment (1) based on measurement data (3) recorded by at least one sensor (2), the method (100) comprising the steps of:
• determining (110) whether the measurement data (3) comprises at least one partial discharge contribution (4) that
∘ is plausible to have been produced by the occurrence of a partial discharge pulse somewhere in the equipment (1) and propagation of the resulting signal to the at least one sensor (2) and that
∘ reappears repeatedly in a statistical manner,
wherein the determining whether a contribution is plausible to be a partial discharge contribution (4) comprises: in response to determining (111) that a plurality of pulses have a consistent pulse form given by the propagation or transfer of the signal from their source to the at least one sensor (2), determining (112) that the pulses are partial discharge pulses coming from the same origin; and
• if at least one such partial discharge contribution (4) is present, determining (120) that partial discharges are occurring in the equipment (1).

2. The method (100) of claim 1, wherein, in response to determining (113) that an essentially common pulse form or a part thereof is distributed statistically at different instance in time within the measurement signal, it is determined (114) that at least one partial discharge contribution (4) is present.

3. The method (100) of any one of claims 1 and 2, wherein the presence of a consistent or essentially common pulse form is determined (113a) by computing at least one correlation between the measurement data (3) or a part thereof within a certain time interval on the one hand, and a version of the measurement data (3) or a part thereof shifted in time to another time interval on the other hand.

4. The method (100) of any one of claims 1 to 3, further comprising: determining (130), from at least one partial discharge contribution (4), the transfer function (5) for propagation of the signal of a partial discharge pulse to the at least one sensor (2).

5. The method (100) of claim 4, further comprising: determining (140), based at least in part on the transfer function (5), a pulse shape (6) of at least one partial discharge pulse.

6. The method (100) of any of claims 4 to 5 , wherein the determining of the transfer function (5) is performed (131) based at least in part on a priori knowledge about the shape of the partial discharge pulse.

7. The method (100) of claim 6, wherein starting points for lengths and/or scales of time intervals investigated, and/or choice of correlation times considered, are determined (131a) based at least in part on the a priori knowledge.

8. The method (100) of any one of claims 4 to 7, wherein the determining (130) of the transfer function (5) is based (132) on a model of the propagation that comprises reflection of signals or waves on walls, and/or diffraction and/or deflection of signal on obstacles and/or attenuation of the signal by the media and/or the distance it travels through.

9. The method (100) of any one of claims 1 to 8, wherein determining a signature in the measurement data (3) of a partial discharge pulse from one source comprises (115) coherent averaging of signatures in the measurement data (3) of multiple partial discharge pulses from the same source.

10. The method (100) of any one of claims 1 to 9, wherein the determining (110) of at least one partial discharge contribution (4) comprises:
• obtaining (116) a signature that at least one partial discharge pulse produced in the measurement data (3); and
• searching (117) the measurement data (3) for one or more instances of this signature.

11. The method (100) of claim 10, wherein a time interval to be used to search for one or more instances of the signature is determined (117a) based at least in part on the signature, and/or on the position of this signature in the measurement data (3).

12. The method (100) of any one of claims 1 to 11, wherein, alternatively or in combination to the measurement data (3), a frequency representation and/or time-frequency representation of the measurement data (3) is investigated for the presence of at least one partial discharge contribution (4).

13. The method (100) of any one of claims 1 to 12, wherein the determining (110) whether the measurement data (3) comprises at least one partial discharge contribution (4) comprises detection (118) of a signal energy and/or power introduced into the air or space by a partial discharge event and arriving at the detection unit.

14. The method (100) of claim 13, where the detection (118) of energy or power comprises evaluating (118a) a power spectral density of the measurement data (3) in a predetermined or automatically adjusted frequency range.

15. The method (100) of any one of claims 13 to 14, wherein the detection (118) of energy or power comprises:
• calculating (118b), from the measurement data (3), a root mean square of the introduced power, and/or an energy average;
• calculating (118c) the expected signal decay due to reflections at walls, the inverse distance law, or the attenuation by the medium;
• removing or correcting (118d) the effects of this decay from the root mean square, thereby obtaining a corrected power; and
• in response to determining (118e) that the corrected power contains at least one positive change as a function of the time, determining (118f) that this positive change corresponds to at least one partial discharge pulse.

16. The method (100) of any one of claims 1 to 15, further comprising: determining (150), from the measurement data (3) and the known transfer function (5), a precise moment in time (7a), or a precise phase angle (7b) with respect to an AC voltage, at which a partial discharge event occurs.

17. The method (100) of any one of claims 1 to 16, further comprising: determining (160), from the at least one partial discharge contribution (4), a (relative) strength (9) of the partial discharge.

18. The method (100) of claim 17, wherein the determining of the strength of the partial discharge comprises:
• obtaining (161), based on at least one signature of the partial discharge, calibration information; and
• computing (162) the strength (9) of the partial discharge based at least in part on a strength of the partial discharge contribution and the calibration information.

19. The method (100) of any one of claims 1 to 18, wherein multiple partial discharge contributions (4) are determined from the measurement data (3).

20. The method (100) of claim 19, wherein, in response to determining that the measurement data (3) comprises at least one partial discharge contribution (4),
• this partial discharge contribution (4) is removed (170) from the measurement data (3), thereby producing remaining to-be-analyzed measurement data (3'); and
• determining (180) whether this remaining to-be-analyzed measurement data (3') comprises at least one further partial discharge contribution (4).

21. The method (100) of any one of claims 1 to 20, further comprising: evaluating (190), from the transfer function (5),
• a distance between the location of the partial discharge event and the at least one sensor (2), and/or
• a path between the location of the partial discharge event and the at least one sensor (2), and/or
• whether the partial discharge event occurs only in one location or in multiple locations.

22. The method (100) of any one of claims 1 to 21, further comprising: determining (200), based at least in part on the transfer function (5) and/or the pulse shape and/or the temporal or phase distribution of partial discharge events from this location, a severity rating (8) of the partial discharge pulse with regard to proper functioning of the equipment (1).

23. The method (100) of claim 22, wherein the severity rating (8) is dependent (201) at least on whether at least one partial discharge contribution (4) has always been present during operation of the equipment (1) or has set in at a later point in time during this operation.

24. The method (100) of any one of claims 1 to 23, where the measurement is based on an acoustic signal or measurement principle.

25. The method (100) of any one of claims 1 to 24, where the measurement is based on an electromagnetic wave signal or measurement principle, such as UHF.

26. A computer program, comprising machine-readable instructions that, when executed on one or more computers and/or compute instances, cause the one or more computers and/or compute instances to perform the method (100) of any one of claims 1 to 25.

27. A non-transitory machine-readable data carrier, and/or a download product, with the computer program of claim 26.

28. One or more computers and/or compute instances with the computer program of claim 26, and/or with the machine-readable data carrier and/or download product of claim 27.
